# FASCICULE DE BREVET EUROPEEN

(11) **EP 3 164 452 B1**
(45) Date de publication et mention de la délivrance du brevet: **25.07.2018**
(21) Numéro de dépôt: 15745526.2
(22) Date de dépôt: 26.06.2015
(51) Int. Cl.: C08L 23/08, C08K 5/14, C08K 5/5425, C08L 33/08, C08L 33/10, C08L 33/12, H01L 31/048

(54) **ENCAPSULANT D'UN MODULE PHOTOVOLTAÏQUE**
VERKAPSELUNGSMITTEL EINES PHOTOVOLTAIKMODULS
ENCAPSULANT OF A PHOTOVOLTAIC MODULE

(30) Priorité: 02.07.2014 FR 1456309
(43) Date de publication de la demande: 10.05.2017
(73) Titulaire: Arkema France, 92700 Colombes (FR)
(72) Inventeur: JACQUES, Guillaume, F-76500 Elboeuf (FR); BIZET, Stéphane, F-27170 Barc (FR); SAVIGNAT, Benoît, F-27300 Bernay (FR); CANNET, Molly, F-28200 Chateaudun (FR)
(74) Mandataire: Gorintin, Sarah
(86) Numéro de dépôt international: PCT/FR2015/051733
(87) Numéro de publication internationale: WO 2016/001540

(56) Documents cités:
- WO-A1-03/085681
- FR-A1- 2 981 655
- JP-A- 2005 002 245

## Description

### Domaine de l'invention

L'invention a pour objet un encapsulant de module photovoltaïque à base d'un copolymère d'éthylène - acrylate d'alkyle dans laquelle un agent de réticulation (peroxydes ou isocyanates ou touts autres composants ayant une fonction de réticulation) n'est présent que dans des proportions très réduites. La présente invention concerne également un module photovoltaïque, ou l'utilisation de cette composition d'encapsulant dans un tel module, comprenant, outre la couche d'encapsulant, au moins une couche adjacente formant « frontsheet » ou « backsheet », plus généralement ces trois couches successives, « frontsheet », encapsulant et « backsheet ».

Le réchauffement climatique, lié aux gaz à effet de serre dégagés par les énergies fossiles, a mené au développement de solutions énergétiques alternatives qui n'émettent pas de tels gaz lors de leur fonctionnement, comme par exemple les modules photovoltaïques. Un module photovoltaïque comprend une «pile photovoltaïque», cette pile étant capable de transformer l'énergie lumineuse en électricité.

Il existe de nombreux types de structures de panneaux photovoltaïques.

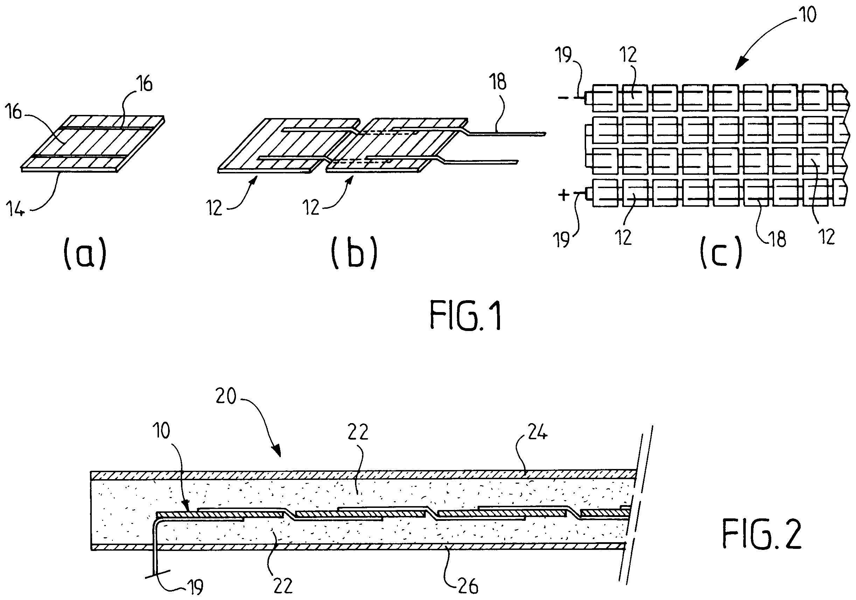

Sur la Figure 1, on a représenté une pile photovoltaïque classique ; cette pile photovoltaïque 10 comprend des cellules 12, une cellule contenant un capteur photovoltaïque 14, généralement à base de silicium traité afin d'obtenir des propriétés photoélectriques, en contact avec des collecteurs d'électrons 16 placés au-dessus (collecteurs supérieurs) et au-dessous (collecteurs inférieurs) du capteur photovoltaïque. Les collecteurs 16 supérieurs d'une cellule sont reliés aux collecteurs 16 inférieurs d'une autre cellule 12 par des barres conductrices 18, constituées généralement d'un alliage de métaux. Toutes ces cellules 12 sont connectées entre elles, en série et/ou en parallèle, pour former la pile photovoltaïque 10. Lorsque la pile photovoltaïque 10 est placée sous une source lumineuse, elle délivre un courant électrique continu, qui peut être récupéré aux bornes 19 de la pile 10.

En référence à la Figure 2, le module photovoltaïque 20 comprend la pile photovoltaïque 10 de la Figure 1 enrobée dans un « encapsulant », celui-ci étant composé d'une partie supérieure 22 et d'une partie inférieure 23. Une couche protectrice supérieure 24 (connue en anglais sous le terme « frontsheet », utilisé dans la suite) et une couche protectrice au dos du module (connue en anglais sous le terme « backsheet », également utilisé dans la suite) 26 sont disposées de part et d'autre la pile encapsulée.

La protection au choc et à l'humidité de la pile photovoltaïque 10 est assurée par la couche protectrice supérieure 24, généralement en verre.

Le backsheet 26, par exemple un film multicouche à base de polymère fluoré et de polyéthylène téréphtalate, contribue à la protection à l'humidité du module photovoltaïque 20 et à l'isolation électrique des cellules 12 pour éviter tout contact avec l'environnement extérieur.

L'encapsulant 22 doit épouser parfaitement la forme de l'espace existant entre la pile photovoltaïque 10 et les couches protectrices 24 et 26 afin d'éviter la présence d'air, ce qui limiterait le rendement du module photovoltaïque. L'encapsulant 22 doit également empêcher le contact des cellules 12 avec l'eau et l'oxygène de l'air, afin d'en limiter la corrosion. La partie supérieure de l'encapsulant 22 est comprise entre la pile 10 et la couche protectrice supérieure 24. La partie inférieure de l'encapsulant 22 est comprise entre la pile 10 et le backsheet 26.

En présence de rayonnement solaire, il se crée un échauffement à l'intérieur du module solaire et des températures de 80°C (ou plus) peuvent être atteintes ce qui nécessite que les couches soient parfaitement liées les unes aux autres tout au long du cycle de vie du module.

### Etat de l'art

A l'heure actuelle, la majorité du marché de l'encapsulation photovoltaïque correspond à des formulations à base d'un EVA dans lequel on ajoute un peroxyde, un silane et divers additifs fonctionnels.

L'EVA présente beaucoup de qualités et de propriétés intéressantes pour cette application. Il confère en effet principalement de très bonnes propriétés de transparence, de tenue mécanique, de résistance au vieillissement et de manière générale d'excellentes propriétés thermomécanique et mécanique. Par ailleurs, ce thermoplastique est relativement peu couteux de sorte que son emploi pour cette application est devenu quasiment incontournable.

Néanmoins, le type d'encapsulant à base d'EVA, avec peroxyde et silane, présente un inconvénient majeur.

En effet, lorsque les conditions d'environnements sont dégradées, c'est-à-dire lorsque l'encapsulant EVA vieillit dans des environnements chauds et humides (DHT «Damp Heat Test» : 85°C / 85% HR «Humidité Relative»), ce composant est sujet à de l'hydrolyse qui provoque l'apparition d'acide acétique, source de jaunissement de l'encapsulant et de corrosion des connectiques métalliques du module photovoltaïque.

L'homme du métier pourrait envisager le remplacement de l'EVA par un copolymère éthylène - acrylate d'alkyle mais cette solution, qui évite certes les problèmes spécifiques liés à l'EVA lorsque celui-ci est présent dans un environnement difficile, ne permet pas l'obtention d'un module photovoltaïque correct. En effet, lors de la lamination, de nombreuses bulles se forment au cours de la réticulation en raison du peroxyde présent en quantités notables. Par ailleurs, le document WO 2006095911 propose une solution par l'utilisation d'une formulation à base d'un copolymère éthylène - acrylate d'alkyle dont la température de fusion (T en °C), obtenue selon la norme JIS K 7121, répondrait à la formule suivante : -3.0X+125 > T >-3.0X+109. L'élément X représentant le taux molaire du comonomère polaire (acrylate). Par ailleurs ce document propose l'association à ce copolymère d'un silane afin d'apporter les propriétés adhésives sur le verre.

Cependant, une telle formulation ne permettrait pas l'obtention d'un encapsulant performant sur le long terme. Le silane présente en effet l'inconvénient de ne pas permettre un bon niveau d'adhésion sur le verre lorsqu'il n'est pas chimiquement lié au polymère.

Ainsi, il est recherché à l'heure actuelle une solution d'encapsulation à base d'un composant alternatif à l'EVA, présentant des propriétés tout aussi intéressantes, tout en éliminant le risque de dégagement d'acide acétique.

Cette solution devra par ailleurs permettre l'utilisation de silane, qui permet en particulier la fixation aux parois du « frontsheet », c'est-à-dire à un composant en verre céramique ou en verre synthétique (classiquement du PMMA).

### Brève description de l'invention

Il a été constaté par la demanderesse, après diverses expériences et manipulations, qu'une composition à base d'un copolymère d'éthylène - acrylate d'alkyle et de silane pouvait, avec un taux très faible d'agent(s) de réticulation, présenter des propriétés thermomécaniques et des caractéristiques physico-chimiques extrêmement satisfaisantes.

Ainsi, la présente invention concerne un encapsulant de module photovoltaïque, destiné à venir enrober une pile photovoltaïque, comprenant :
- un copolymère éthylène - acrylate d'alkyle, l'indice de fluidité MFI dudit copolymère étant compris entre 1 g/10 min et 40 g/10 min ;
- un silane, représentant entre 0,1% et 0,5% du poids de ladite composition ;
caractérisé en ce qu'elle comprend en outre un agent de réticulation représentant entre 0,1% et 0,5% du poids de la composition et en ce que ledit copolymère représente au moins 99% du poids de ladite composition.

La demanderesse a en effet découvert qu'il y avait un intérêt tout particulier à réaliser une « réticulation incomplète ». L'agent de réticulation, de préférence choisi dans la famille des monoperoxycarbonate et plus précisément consistant en le Luperox® TBEC ou (OO-tert-butyl-O-(2-éthylhexyle)-monoperoxycarbonate), présent en très faible quantité, permet le greffage du silane sur le copolymère et réticule suffisamment ce dernier pour le rendre résistant au fluage sans avoir à atteindre un niveau de gel significatif. Ce taux très réduit de peroxyde évite tout problème d'apparition de bulles à l'étape de lamination.

Cette « réticulation incomplète » présente l'avantage de pouvoir être réalisée à l'étape de lamination, comme réalisée actuellement, mais également dès l'extrusion du film encapsulant, permettant ainsi ensuite une lamination plus rapide.

La composition selon l'invention présente en premier lieu les avantages suivants :
- l'impossibilité d'apparition d'acide acétique, plus généralement d'aucun acide, au cours de son utilisation quelles que soient les conditions d'environnements ;
- le maintien d'excellentes propriétés adhésives de la composition tout au long de la durée de vie de la composition, en particulier dans son emploi en tant qu'encapsulant d'un module photovoltaïque ;
- améliorer les propriétés optiques au cours du vieillissement dans un environnement difficile ;
- le maintien d'excellentes propriétés thermomécaniques et de caractéristiques physico-chimiques, au moins aussi satisfaisantes que la solution actuelle à base d'EVA (agent de réticulation et silane).

D'autres caractéristiques et particularités du mélange primaire de l'invention sont présentées ci-après :
- avantageusement, l'agent de réticulation appartient à la famille des monoperoxycarbonate, de préférence consiste en le OO-tert-butyl-O-(2-éthylhexyle)-monoperoxycarbonate ;
- de préférence, pour le susdit copolymère, le taux massique d'éthylène est compris entre 50% et 85%, de préférence entre 60% et 84%, et le taux massique d'acrylate d'alkyle est compris entre 15% et 50%, de préférence entre 16% et 40% ;
- avantageusement, le silane consiste en un vinyl silanes ou silanes (meth)acryliques.
- selon une précision non limitative de l'invention, le silane consiste en le methacryloxypropylsilane.
- avantageusement, l'agent de réticulation représente moins de 0,3% du poids de la composition.
- de préférence le susdit copolymère présente un indice de fluidité MFI compris entre 2 g/10 min et 10 g/10 min.
- selon une possibilité » offerte par l'invention, la composition consiste uniquement en les susdits copolymère, agent de réticulation et silane.
- selon une autre possibilité offerte par l'invention, la composition comprend en outre des additifs destinés à conférer des propriétés particulières additionnelles, en particulier des plastifiants, des promoteurs d'adhésion, des stabilisants et absorbeurs UV, des antioxydants, des agents retardateurs de flamme et/ou des charges.

L'invention se rapporte également à l'utilisation de l'encapsulant tel que décrit ci-dessus dans un module photovoltaïque.

Enfin, l'invention se rapporte à un module photovoltaïque comprenant une structure constituée d'une association d'au moins un encapsulant et un frontsheet ou backsheet, caractérisé en ce que l'encapsulant est tel que décrit ci-dessus.

### Description des Figures annexées

La description qui va suivre est donnée uniquement à titre illustratif et non limitatif en référence aux figures annexées, dans lesquelles :
La Figure 1, déjà décrite, représente un exemple de pile photovoltaïque, les parties (a) et (b) étant des vues de ¾, la partie (a) montrant une cellule avant connexion et la partie (b) une vue après connexion de 2 cellules ; la partie (c) est une vue de dessus d'une pile photovoltaïque complète.
La Figure 2, déjà décrite, représente une coupe transversale d'un module photovoltaïque, dont le capteur photovoltaïque « classique » est encapsulé par un film d'encapsulant supérieur et un film d'encapsulant inférieur.

### Description détaillée de l'invention

S'agissant du copolymère éthylène - acrylate d'alkyle, il s'agit d'un composant bien connu de l'homme du métier. Les particularités propres à ce copolymère, dans le cadre de la présente invention, proviennent essentiellement des proportions massiques (ou en poids) d'éthylène et d'acrylate d'alkyle et de l'indice de fluidité MFI du copolymère, exprimé en grammes par 10 minutes et mesuré à 190°C sous une charge de 2,16kg.

Le taux massique d'éthylène étant compris entre 50% et 85%, de préférence entre 60% et 84%, et le taux massique d'acrylate d'alkyle est compris entre 15% et 50%, de préférence entre 16% et 40%.

L'indice de fluidité MFI (« Melt Flow Index ») du copolymère étant compris entre 1 g/10 min et 40 g/10 min, de préférence entre 2 g/10min et 10 g/10min.

A titre d'exemple non limitatif, la demanderesse exploite commercialement un composant dénommé LOTRYL® qui est un copolymère éthylène - acrylate d'alkyle.

L'homme du métier sait parfaitement comment réaliser/fabriquer un tel copolymère, selon les différentes quantités de chacun des deux monomères. Dans la suite, l'invention est présentée avec un copolymère éthylène - acrylate d'alkyle de type spécifique mais il a été démontré par la titulaire que la composition d'encapsulant selon l'invention répondait aux objectifs fixés lorsque le copolymère varie dans les domaines de taux d'éthylène et d'acrylate d'alkyle définis ci-dessus, éventuellement de façon légèrement supérieure lorsque ledit copolymère présente des taux d'éthylène et d'acétate de vinyle choisis dans les domaines préférés pour ces deux monomères.

S'agissant du silane, ce sont des composés chimiques permettant les interactions d'adhésion entre l'encapsulant et le verre. A titre d'exemples de silane, on peut citer les le methacrylate de 3-trimethoxysilyl propyle, le vinyl trimethoxysilane ou tout autre silane porteur d'une fonction réactive vis-à-vis d'un agent de réticulation type peroxyde. De préférence, le silane dans la composition selon l'invention est le methacrylate de 3-trimethoxysilyl propyle. Néanmoins, on obtiendrait des résultats équivalents ou sensiblement équivalents en choisissant un autre silane de la famille des vinyl silanes ou silanes (meth)acryliques.

S'agissant de l'agent de réticulation, cet élément se décomposant pour amorcer et propager des réactions chimiques (avec le silane pour le greffage de ce dernier sur les chaines de copolymères) et de réticulation (du copolymère) est bien connu de l'homme du métier et il ne présente aucune difficulté pour sa fabrication/préparation.

Il doit être noté ici qu'une famille particulière d'agent de réticulation répond le mieux aux objectifs fixés dans le cadre de la présente demande de brevet : il s'agit des monoperoxycarbonates, et parmi eux en particulier le OO-tert-butyl-O-(2-éthylhexyle)-monoperoxycarbonate qui est vendu notamment par la demanderesse sous la marque Luperox® TBEC.

La composition formant l'encapsulant selon l'invention pourra éventuellement comprendre un certain nombre d'additifs destinés à conférer des propriétés particulières additionnelles.

Des plastifiants pourront être ajoutés afin de faciliter la mise en oeuvre et améliorer la productivité du procédé de fabrication de la composition et des structures. On citera comme exemples les huiles minérales paraffiniques aromatiques ou naphtaléniques qui permettent également d'améliorer le pouvoir d'adhérence de la composition selon l'invention. On peut également citer comme plastifiant les phtalates, azelates, adipates, le phosphate de ticrésyle.

Des promoteurs d'adhésion, bien que non nécessaires, peuvent être avantageusement ajoutés afin d'améliorer le pouvoir d'adhérence de la composition lorsque celui-ci doit être particulièrement élevé. Le promoteur d'adhésion est un ingrédient non polymérique ; il peut être organique, cristallin, minéral et plus préférentiellement semi-minéral semi-organique. Parmi ceux-ci, on peut citer les titanates.

Dans cette application particulière de la composition aux modules photovoltaïques, le rayonnement UV étant susceptible d'entraîner un léger jaunissement de la composition utilisée en tant qu'encapsulant desdits modules, des stabilisants UV et des absorbeurs UV tels que le benzotriazole, le benzophénone et les autres amines encombrés, peuvent être ajoutés afin d'assurer la transparence de l'encapsulant durant sa durée de vie. Ces composés peuvent être par exemple à base de benzophénone ou de benzotriazole. On peut les ajouter dans des quantités inférieures à 10% en masse de la masse totale de la composition et préférentiellement de 0,05 à 3%.

On pourra également ajouter des anti-oxydants pour limiter le jaunissement lors de la fabrication de l'encapsulant tels que les composés phosphorés (phosphonites et/ou phosphites) et les phénoliques encombrés. On peut ajouter ces anti-oxydants dans des quantités inférieures à 10% en masse de la masse totale de la composition et préférentiellement de 0,05 à 3%.

Des agents retardateurs de flamme peuvent également être ajoutés. Ces agents peuvent être halogénés ou non-halogénés. Parmi les agents halogénés, on peut citer les produits bromés. On peut également utiliser comme agent non-halogéné les additifs à base de phosphore tels que le phosphate d'ammonium, de polyphosphate, de phosphinate ou de pyrophosphate, le cyanurate de mélamine, le pentaérythritol, les zéolithes ainsi que les mélanges de ces agents. La composition peut comprendre ces agents dans des proportions allant de 3 à 40% par rapport à la masse totale de la composition.

On peut également ajouter des pigments comme par exemple le dioxyde de titane, des composés colorants ou azurants dans des proportions allant généralement de 5% à 15% par rapport à la masse totale de la composition.

Des charges, en particulier minérales, peuvent également être ajoutées pour améliorer la tenue thermomécanique de la composition. De façon non limitative, on donnera comme exemples la silice, l'alumine ou les carbonates de calcium ou les nanotubes de carbone ou encore les fibres de verre. On pourra utiliser des argiles modifiées ou non modifiées qui sont mélangées à l'ordre nanométrique ; ceci permet d'obtenir une composition encore plus transparente.

### Réticulation/préparation de l'encapsulant et production d'un film encapsulant selon l'invention (destiné à être incorporé dans un module photovoltaïque) :

Classiquement, une réticulation est nécessaire pour adapter les propriétés thermomécaniques de l'encapsulant à base d'EVA, en particulier lorsque la température devient très élevée. En l'occurrence, dans le cadre de la présente invention, la réticulation n'est pas complète du fait d'un très faible taux d'agent(s) de réticulation, mais permet le greffage du silane sur les chaines de copolymère et une réticulation partielle de ce copolymère.

Les autres éléments de la composition, à savoir le silane et éventuellement les charges, sont ajoutés à l'agent de réticulation et au susdit copolymère de manière classique, bien connus de l'homme du métier.

Relativement aux aspects susvisés, le manuel intitulé « Handbook of polymer foams and technology », notamment aux pages 198 à 204, fournit des enseignements complémentaires auxquels l'homme du métier peut se référer.

Concernant les aspects de l'invention relatifs à l'utilisation de la composition thermoplastique dans un module photovoltaïque, l'Homme de l'Art peut se référer par exemple au Handbook of Photovoltaic Science and Engineering, Wiley, 2003. En effet, la composition de l'invention peut être utilisée en tant qu'encapsulant ou encapsulant-backsheet dans un module photovoltaïque, dont on décrit la structure en relation avec les figures annexées.

### Matériaux employés pour former les formulations testées :

Lotryl® 17BA07 : copolymère éthylène - acrylate de butyle dont le taux d'acrylate est de 17% en poids du copolymère et le MFI de 7 g/10 min. (190°C, 2,13 kg). Il est obtenu selon un procédé autoclave et sa température de fusion est de 89°C.
Dans les tableaux de résultats présentés ci-après, ce Lotryl® est noté par les initiales 17BA07.

Lotryl® 20MA08 : copolymère éthylène - acrylate de méthyle dont le taux d'acrylate est de 20% en poids du copolymère et le MFI de 8 g/10 min. (190°C, 2,13 kg). Il est obtenu selon un procédé autoclave et sa température de fusion est de 75°C.
Dans les tableaux de résultats présentés ci-après, ce Lotryl® est noté par les initiales 20MA08.

Lotryl® 35BA40 : copolymère éthylène - acrylate de butyle dont le taux d'acrylate est de 35% en poids du copolymère et le MFI de 40 g/10 min. (190°C, 2,13 kg). Il est obtenu selon un procédé autoclave et sa température de fusion est de 66°C
Dans les tableaux de résultats présentés ci-après, ce Lotryl® est noté par les initiales 35BA40.

Lotryl® 35BA320 : copolymère éthylène - acrylate de butyle dont le taux d'acrylate est de 35% en poids du copolymère et le MFI de 320 g/10 min. (190°C, 2,13 kg). Il est obtenu selon un procédé autoclave et sa température de fusion est de 65°C
Dans les tableaux de résultats présentés ci-après, ce Lotryl® est noté par les initiales 35BA320.

Lotryl® 28MA07 : copolymère éthylène - acrylate de méthyle dont le taux d'acrylate est de 28% en poids du copolymère et le MFI de 7 g/10 min. (190°C, 2,13 kg). Il est obtenu selon un procédé autoclave et sa température de fusion est de 68°C
Dans les tableaux de résultats présentés ci-après, ce Lotryl® est noté par les initiales 28MA07.

Lotryl® 7BA01 : copolymère éthylène - acrylate de butyle dont le taux d'acrylate est de 7% en poids du copolymère et le MFI de 1 g/10 min. (190°C, 2,13 kg). Il est obtenu selon un procédé autoclave et sa température de fusion est de 105°C.
Dans les tableaux de résultats présentés ci-après, ce Lotryl® est noté par les initiales 7BA01.

Evatane® 3345PV : copolymère éthylène - acétate de vinyle dont le taux d'acétate est de 33% en poids du copolymère et le MFI de 45 g/10 min. (190°C, 2,13 kg). Dans les tableaux de résultats présentés ci-après, cet Evatane® est noté par les initiales 3345PV.

Dynasylan MEMO : 3-MethacryloxypropylTrimethoxySilane vendu par la société Evonik. Dans les tableaux de résultats présentés ci-après, ce silane est noté par les initiales MTS.

Luperox® TBEC : OO-tert-butyl-O-(2-éthylhexyle)-monoperoxycarbonate, vendu par la société demanderesse Arkema, noté dans la suite TBEC

Luperox® 101 : 2,5-diméthyl-2,5-di(tert-butylperoxy)-hexane, vendu par la société demanderesse Arkema, noté dans la suite 101

### Obtention des films et formulations testées :

### Réalisation des films :

Les films encapsulants sont obtenus par extrusion de granulés de polymères imprégnés :
Les silanes et, le cas échéant, le peroxyde sont ajoutés par imprégnation des granulés de Lotryl ou Evatane. Granulés et liquide sont placés dans un flacon et le flacon est disposé sur un mélangeur à rouleaux durant 3 heures à la vitesse de 60 rotations par minute.

Après imprégnation, ces granulés, ainsi que les granulés éventuellement additionnels, sont placés dans la trémie d'introduction d'une extrudeuse à filière plate de largeur 10 cm.

L'extrusion est réalisée à une température adaptée à la composition, ainsi pour des compositions à base de Luperox TBEC, cette température est limitée à 90°C, car au-delà de celle-ci, le peroxyde se décomposera. Pour des compositions à base de Luperox 101, cette température peut atteindre 100°C à 110°C.

Cette extrusion permet l'obtention d'une bobine de film dont le tirage en sortie d'extrudeuse est réglée de façon à obtenir un film d'épaisseur comprise entre 350 et 550 µm (micromètre).

### Réalisation des modules test :

Afin de caractériser les formulations, des modules-test sont obtenus par lamination à chaud.

La structure d'un module-test est variable selon les caractérisations à réaliser :
- Mesure de fluage et de propriétés optiques par transmission : Verre (4mm) / Film d'encapsulant / Verre (4mm)
- Mesure d'adhésion : Verre (4mm) / Film d'encapsulant / Backsheet Apolhya

Le laminateur utilisé est fourni par la société Penergy. Les conditions de lamination sont dépendantes de la composition des films laminés.

Ainsi dans le cas d'une formulation à base de TBEC, le cycle respecté est le suivant :

| | **Durée (s)** | **T(°C)** | **Vᵤₚ (mBar)** | **V_{down} (mBar)** |
|---|---|---|---|---|
| Prestart | 10 | 85 | 0 | 1000 |
| 1 | 10 | 85 | 0 | 0 |
| 2 | 180 | 85 | 0 | 0 |
| 3 | 10 | 85 | 900 | 0 |
| 4 | 10 | 85 | 1000 | 0 |
| 5 | 600 | 150 | 1000 | 0 |
| 6 | 360 | 150 | 1000 | 0 |
| 7 | 10 | 150 | 0 | 0 |
| 8 | 10 | 150 | 0 | 0 |
| 9 | - | 50 | 0 | 1000 |

Par ailleurs, dans le cas d'une formulation à base de Luperox 101, ta température est ajustée en raison de la température de décomposition plus élevée de ce peroxyde. Le cycle respecté est donc le suivant :

| | **Durée (s)** | **T(°C)** | **Vᵤₚ (mBar)** | **V_{down} (mBar)** |
|---|---|---|---|---|
| Prestart | 10 | 110 | 0 | 1000 |
| 1 | 10 | 110 | 0 | 0 |
| 2 | 180 | 110 | 0 | 0 |
| 3 | 10 | 110 | 900 | 0 |
| 4 | 10 | 110 | 1000 | 0 |
| 5 | 600 | 170 | 1000 | 0 |
| 6 | 360 | 170 | 1000 | 0 |
| 7 | 10 | 170 | 0 | 0 |
| 8 | 10 | 170 | 0 | 0 |
| 9 | - | 50 | 0 | 1000 |

### Tests réalisés sur les éprouvettes (compositions E1 à E4 et EC1 à EC5) :

La présente invention est illustrée plus en détail par les exemples non limitatif suivant.

Les compositions notés El, E2, E3 et E4 dans le tableau ci-dessous sont des compositions conformes à l'invention tandis que les compositions EC1, EC2, EC3, EC4 et EC5 sont des compositions selon l'art antérieur et/ou non conformes à la présente invention.

| | constituant 1 | Taux (% en poids de la composition) | constituant 2 | Taux (% en poids de la composition) | constituant 3 | Taux (% en poids de la composition) |
|---|---|---|---|---|---|---|
| E1 | 28MA07 | 99,5 | MTS | 0,3 | TBEC | 0,2 |
| E2 | 17BA07 | 99,6 | MTS | 0,3 | 101 | 0,1 |
| E3 | 20MA08 | 99,6 | MTS | 0,3 | 101 | 0,1 |
| E4 | 35BA40 | 99,3 | MTS | 0,3 | TBEC | 0,4 |
| EC1 | EVA3345PV | 98,2 | MTS | 0,3 | TBEC | 1,5 |
| EC2 | 20MA08 | 99,7 | MTS | 0,3 | - | - |
| EC3 | 7BA01 | 99,6 | MTS | 0,3 | 101 | 0,1 |
| EC4 | 35BA320 | 99,2 | MTS | 0,3 | TBEC | 0,5 |
| EC5 | 35BA40 | 98,7 | MTS | 0,3 | TBEC | 1,0 |

On notera que les éprouvettes visées ci-dessus présentent des quantités identiques de silane, fixées à 0,3% du poids de la composition. Néanmoins, des tests complémentaires ont permis d'identifier que la quantité de silane dans la composition pouvait être comprise entre 0,1% et 0,5% en poids de ladite composition.

Les exemples de composition selon l'invention présentent toutes les mêmes épaisseurs mais il est bien entendu que l'homme du métier pourra les faire varier en fonction de l'application du module photovoltaïque et des performances de ce dernier.

### Mesures de propriétés optiques par transmittance :

Les propriétés optiques par transmittance sont mesurées sur des structures verre / encapsulant / verre à l'aide d'un spectrocolorimètre de la marque Minolta. Les conditions de mesures sont les suivantes :
▪ Longueur d'onde : 360 nm - 740 nm (nanomètre)
▪ Illuminant : C
▪ Angle : 2°
▪ Ouverture de mesure : LAV 25 mm (millimètre)
▪ Fond : plaque blanche « Cera » + Puits de lumière

Deux données chiffrées sont tirées de cette mesure :
▪ Haze : Le Haze correspond au niveau de trouble de la structure étudié. Il est calculé selon la norme ASTM D-1003-007)
▪ Transparence : le niveau de transparence est calculé en prenant la valeur moyenne de transmittance entre 400 et 740 nm, corrigée des contributions respectives des couches de verre et des interfaces verre/air et verre/encapsulant, puis normalisé à une épaisseur de 200µm. La transparence a également été évaluée au cours d'un vieillissement DHT (Damp Heat Test - 85°C / 85% Humidité relative / 2000h).

Pour satisfaire aux exigences de l'invention, le test de transparence doit montrer un résultat supérieur à 96% et le test de Haze, un résultat inférieur à 20.

### Test de fluage :

Le test de fluage est réalisé sur des structures verre / encapsulant / verre (avec des plaques de verre de longueur L = 70 mm). Après lamination, les modules-test sont placés sur une structure métallique formant un angle de 70° avec l'horizontal. Chaque module est retenu par un rebord recouvrant une partie de l'épaisseur de la première couche de verre.

Cette structure est placée à 100°C dans une étuve. Sous le poids de la seconde couche de verre, un fluage peut-être observé. La valeur de fluage mesurée est donc la distance parcourue par la seconde plaque de verre après 500 heures dans ces conditions. Cette distance est comprise entre 0 mm (pas de fluage) et 70 mm (fluage complet, séparation de la structure).

Pour satisfaire aux exigences de l'invention, la mesure de fluage doit montrer un résultat inférieur à 4mm.

### Test d'adhésion sur une couche de verre :

Le niveau d'adhésion entre l'encapsulant et le verre est mesuré sur des structures verre / encapsulant / backsheet à partir d'un test de pelage à 90° effectué à 50 mm/min (millimètre par minute) sur un dynamomètre Zwick 1445. Le backsheet utilisé pour cette mesure est un monocouche constitué d'Apolhya®, fabriqué et vendu par la demanderesse. Les conditions de mesures sont les suivantes :
▪ Vitesse de déplacement de la traverse : 50 mm/min
▪ Largeur découpe éprouvette : 10 mm
▪ Angle de pelage : 90°

Le résultat d'adhésion est exprimé en N/mm.

Pour satisfaire aux exigences de l'invention, la mesure d'adhésion doit montrer un résultat supérieur à 3,5N/mm.

Des tests sur l'encapsulant ont également été réalisés pour vérifier que cette nouvelle structure conserve d'excellentes propriétés, c'est-à-dire des propriétés identiques, relativement aux propriétés d'un encapsulant conforme à celui décrit dans le document WO 09138679, à savoir notamment concernant ses propriétés mécaniques, thermomécaniques, ignifuges et ses propriétés d'isolation électrique. Ces tests se sont révélés positifs.

Les propriétés de jaunissement de l'encapsulant, formulé tel que décrit dans la présente invention, ont été évaluées au cours d'un vieillissement DHT (Damp Heat Test - 85°C / 85% Humidité relative / 2000h). Les résultats obtenus se sont révélés meilleurs que ceux obtenus pour une formulation selon l'art antérieur.

Les compositions selon l'invention remplissent donc les critères pour pouvoir être très avantageusement utilisée comme liant ou encapsulant dans les modules solaires.

### Résultats des tests réalisés sur les éprouvettes des différentes formulations :

| Compositions | Adhésion (N/mm) | Prop. Opt. Transmittance | | | Fluage 70°/110°C (mm/70mm - 500h) |
|---|---|---|---|---|---|
| | | to | | DHT 2000h | |
| | | %T_{400µm} (%) | Haze | %T_{400µm} (%) | |
| **E1** | 6,7 | 99,5 | 1,5 | 98 | 2,5 |
| **E2** | 3,8 | 94 | 15 | 93,8 | 1,5 |
| **E3** | 6,2 | 98 | 3 | 97,6 | 2 |
| **E4** | 4,6 | 99,7 | 0,9 | 99,2 | 3,5 |
| **EC1*** | 6,2* | 99,6* | 1* | **93,5** | 0* |
| **EC2** | 0,9 | 97,6 | 3,5 | 97 | **70** |
| **EC3** | 3,5 | **91** | **25** | **89,8** | 1 |
| **EC4** | 4,2 | 99,6 | 0,9 | 99,3 | 12 |
| **EC5** | **Aucune mesure réalisée, présence d'une très grande quantité de bulles dans la couche d'encapsulant** | | | | |

| | | | | | |
|---|---|---|---|---|---|
| * Les résultats obtenus sur l'éprouvette EC1 (formulation selon l'art antérieur) sont bons, mais la formation d'acide acétique lors du vieillissement DHT est détectée et provoque un fort jaunissement de cet encapsulant. | | | | | |

Ce phénomène n'est observé sur aucun des échantillons réalisés selon la présente invention.

## Revendications

1. Encapsulant (22) de module photovoltaïque (20), destiné à venir enrober une pile photovoltaïque (10), comprenant :
- un copolymère éthylène - acrylate d'alkyle, l'indice de fluidité MFI dudit copolymère étant compris entre 1 g/10 min et 40 g/10 min ;
- un silane, représentant entre 0,1% et 0,5% du poids de ladite composition ;
**caractérisé en ce qu'**elle comprend en outre un agent de réticulation représentant entre 0,1% et 0,5% du poids de la composition et **en ce que** ledit copolymère représente au moins 99% du poids de ladite composition.

2. Encapsulant (22) selon la revendication 1, **caractérisé en ce que** l'agent de réticulation appartient à la famille des monoperoxycarbonate, de préférence consiste en le OO-tert-butyl-O-(2-éthylhexyle)-monoperoxycarbonate.

3. Encapsulant (22) selon la revendication 1 ou 2, **caractérisé en ce que**, pour le susdit copolymère, le taux massique d'éthylène est compris entre 50% et 85%, de préférence entre 60% et 84%, et le taux massique d'acrylate d'alkyle est compris entre 15% et 50%, de préférence entre 16% et 40%.

4. Encapsulant (22) selon l'une quelconque des revendications précédentes, **caractérisé en ce que** le silane consiste en un vinyl silanes ou silanes (meth)acryliques.

5. Encapsulant (22) selon la revendication 4, **caractérisé en ce que** le silane consiste en le methacrylate de 3-trimethoxysilyl propyle.

6. Encapsulant (22) selon l'une quelconque des revendications précédentes, **caractérisé en ce que** l'agent de réticulation représente moins de 0,3% du poids de la composition.

7. Encapsulant (22) selon l'une quelconque des revendications précédentes, **caractérisé en ce que** le susdit copolymère présente un indice de fluidité MFI compris entre 2 g/10 min et 10 g/10 min.

8. Encapsulant (22) selon l'une quelconque des revendications précédentes, **caractérisé en ce que** la composition consiste uniquement en les susdits copolymère, agent de réticulation et silane.

9. Encapsulant (22) selon l'une quelconque des revendications 1 à 7, **caractérisé en ce que** la composition comprend en outre des additifs destinés à conférer des propriétés particulières additionnelles, en particulier des plastifiants, des promoteurs d'adhésion, des stabilisants et absorbeurs UV, des antioxydants, des agents retardateurs de flamme et/ou des charges.

10. Utilisation de l'encapsulant (22) selon l'une quelconque des revendications précédentes dans un module photovoltaïque (20).

11. Module photovoltaïque (20) comprenant une structure constituée d'une association d'au moins un encapsulant (22) et un frontsheet (24) ou un backsheet (26), **caractérisé en ce que** l'encapsulant (22) est selon l'une quelconque des revendications précédentes.

## Patentansprüche

1. Verkapselungsmittel (22) eines Photovoltaikmoduls (20), das zum Umhüllen einer Photovoltaikzelle (10) bestimmt ist, enthaltend:
- ein Ethylen-Alkylacrylat-Copolymer, wobei der Schmelzflussindex MFI des Copolymers im Bereich zwischen 1 g/10 min und 40 g/10 min liegt;
- ein Silan, das zwischen 0,1 Gew.-% und 0,5 Gew.-% der Zusammensetzung ausmacht;
**dadurch gekennzeichnet, dass** es ferner ein Vernetzungsmittel enthält, das zwischen 0,1 % und 0,5 Gew.-% der Zusammensetzung ausmacht und dadurch, dass das Copolymer mindestens 99 Gew.-% der Zusammensetzung ausmacht.

2. Verkapselungsmittel (22) nach Anspruch 1, **dadurch gekennzeichnet, dass** das Vernetzungsmittel zur Monoperoxycarbonatfamilie gehört, vorzugsweise aus OO-tert-Butyl-O-(2-ethylhexyl)-monoperoxycarbonat besteht.

3. Verkapselungsmittel (22) nach Anspruch 1 oder 2, **dadurch gekennzeichnet, dass** für das vorgenannte Copolymer der Gewichtsanteil an Ethylen zwischen 50 % und 85 %, vorzugsweise zwischen 60 % und 84 % liegt und der Gewichtsanteil an Alkylacrylat zwischen 15 % und 50 %, vorzugsweise zwischen 16 % und 40 % liegt.

4. Verkapselungsmittel (22) nach einem der vorhergehenden Ansprüche, **dadurch gekennzeichnet, dass** das Silan aus einem Vinylsilanen oder (Meth)acrylsilanen besteht.

5. Verkapselungsmittel (22) nach Anspruch 4, **dadurch gekennzeichnet, dass** das Silan aus 3-Trimethoxysilylpropylmethacrylat besteht.

6. Verkapselungsmittel (22) nach einem der vorhergehenden Ansprüche, **dadurch gekennzeichnet, dass** das Vernetzungsmittel weniger als 0,3 Gew.-% der Zusammensetzung ausmacht.

7. Verkapselungsmittel (22) nach einem der vorhergehenden Ansprüche, **dadurch gekennzeichnet, dass** das vorgenannte Copolymer einen MFI im Bereich zwischen 2 g/10 min und 10 g/10 min aufweist.

8. Verkapselungsmittel (22) nach einem der vorhergehenden Ansprüche, **dadurch gekennzeichnet, dass** die Zusammensetzung nur aus dem vorgenannten Copolymer, Vernetzungsmittel und Silan besteht.

9. Verkapselungsmittel (22) nach einem der Ansprüche 1 bis 7, **dadurch gekennzeichnet, dass** die Zusammensetzung ferner Additive enthält, die dazu bestimmt sind, zusätzliche spezielle Eigenschaften zu verleihen, insbesondere Weichmacher, Haftvermittler, Stabilisatoren und UV-Absorber, Antioxidantien, Flammschutzmittel und/oder Füllstoffe.

10. Verwendung des Verkapselungsmittels (22) nach einem der vorhergehenden Ansprüche in einem Photovoltaikmodul (20).

11. Photovoltaikmodul (20), enthaltend eine Struktur, die aus einer Verbindung von mindestens einem Verkapselungsmittel (22) und einer Vorderschicht (24) oder einer Rückschicht (26) besteht, **dadurch gekennzeichnet, dass** das Verkapselungsmittel (22) gemäß einem der vorhergehenden Ansprüche ist.

## Claims

1. An encapsulant (22) of a photovoltaic module (20), intended to encase a photovoltaic cell (10), comprising:
- an ethylene/alkyl acrylate copolymer, the melt flow index, MFI, of said copolymer being between 1 g/10 min and 40 g/10 min;
- a silane, representing between 0.1% and 0.5% of the weight of said composition;
**characterized in that** it additionally comprises a crosslinking agent representing between 0.1% and 0.5% of the weight of the composition and **in that** said copolymer represents at least 99% of the weight of said composition.

2. The encapsulant (22) as claimed in claim 1, **characterized in that** the crosslinking agent belongs to the monoperoxycarbonate family, preferably consists of OO-tert-butyl O-(2-ethylhexyl) monoperoxycarbonate.

3. The encapsulant (22) as claimed in claim 1 or 2, **characterized in that**, for the abovesaid copolymer, the weight content of ethylene is between 50% and 85%, preferably between 60% and 84%, and the weight content of alkyl acrylate is between 15% and 50%, preferably between 16% and 40%.

4. The encapsulant (22) as claimed in any one of the preceding claims, **characterized in that** the silane consists of a vinyl silane or (meth)acrylic silanes.

5. The encapsulant (22) as claimed in claim 4, **characterized in that** the silane consists of 3-(trimethoxysilyl)propyl methacrylate.

6. The encapsulant (22) as claimed in any one of the preceding claims, **characterized in that** the crosslinking agent represents less than 0.3% of the weight of the composition.

7. The encapsulant (22) as claimed in any one of the preceding claims, **characterized in that** the abovesaid copolymer has a melt flow index, MFI, between 2 g/10 min and 10 g/10 min.

8. The encapsulant (22) as claimed in any one of the preceding claims, **characterized in that** the composition consists solely of the abovesaid copolymer, the abovesaid crosslinking agent and the abovesaid silane.

9. The encapsulant (22) as claimed in any one of claims 1 to 7, **characterized in that** the composition additionally comprises additives intended to confer additional specific properties, in particular plasticizers, adhesion promoters, UV stabilizers and absorbers, antioxidants, flame retardants and/or fillers.

10. The use of the encapsulant (22) as claimed in any one of the preceding claims in a photovoltaic module (20).

11. A photovoltaic module (20) comprising a structure consisting of a combination of at least one encapsulant (22) and a frontsheet (24) or a backsheet (26), **characterized in that** the encapsulant (22) is as claimed in any one of the preceding claims.
